Europäisches Patentamt

European Patent Office (11) Publication number: **0 044 977**

Office européen des brevets **B1**

(12) **EUROPEAN PATENT SPECIFICATION**

(45) Date of publication of patent specification: **25.06.86**

(51) Int. Cl.⁴: **G 11 C 11/00,** G 11 C 11/24, G 11 C 17/00

(21) Application number: **81105221.6**

(22) Date of filing: **06.07.81**

(54) **Latent image memory device using single-FET read-write memory cells.**

(30) Priority: **28.07.80 US 173240**

(43) Date of publication of application: **03.02.82 Bulletin 82/05**

(45) Publication of the grant of the patent: **25.06.86 Bulletin 86/26**

(84) Designated Contracting States: **DE FR GB**

(56) References cited:
US-A-3 755 793
US-A-4 014 036

IBM TECHNICAL DISCLOSURE BULLETIN, vol. 20, no. 3, August 1977, page 951, New York, USA R.J. FURLONG et al.: "Latent images in charge storage memories"

IBM TECHNICAL DISCLOSURE BULLETIN, vol. 18, no. 3, August 1975, pages 651-653, New York, USA J.J. CHANG et al.: "Dynamic one-device storage cell with non-volatile backup mode"

(73) Proprietor: **International Business Machines Corporation**
**Old Orchard Road**
**Armonk, N.Y. 10504 (US)**

(72) Inventor: **Cochran, William Hugh**
**712 22nd Street NE**
**Rochester Minnesota 55901 (US)**
Inventor: **Wu, Philip Tung**
**911 28th Street NW**
**Rochester Minnesota 55901 (US)**

(74) Representative: **Blakemore, Frederick Norman et al**
**IBM United Kingdom Patent Operations Hursley Park**
**Winchester, Hants, SO21 2JN (GB)**

Courier Press, Leamington Spa, England.

## Description

The present invention relates to static information storage, and in accordance with one embodiment concerns an integrated-circuit semiconductor read/write memory whose storage cells additionally contain a personalizable, selectively readable pattern of read-only data.

Semiconductor memories are divided into two major categories. Read/write memories (sometimes mislabelled RAM) have storage cells whose contents are freely alterable, while read-only memories (termed ROM or ROS) contain fixed data which is not changeable except by a lengthy programming or personalization process.

Frequently, however, a need arises for a memory which is basically read/write, yet which can also evoke a fixed, non-volatile, latent-image data pattern. Microprocessor-based controllers and small data-processing systems, for example, commonly require initialization programs upon power-up, but these programs are thereafter dispensable and can be overwritten with operating programs or data. Several approaches have been taken to provide such a function. Physically separate read/write and read-only memory integrated-circuit chips may be selectively enabled in the same address space, for instance. Separate read/write and read-only storage cells may be placed on the same chip, as in U.S. patent 4,193,128 to Brewer. Separate transistors may even be placed in the same cell to provide these two modes, as in U.S. patent 4,095,281 to Denes. Geometric asymmetry of a read/write cell for storing read-only data has been proposed in U.S. patents 3,662,351 and 3,820,086 to Ho et al, in U.S. patent 3,801,967 to Berger et al and in the IBM Technical Disclosure Bulletin, May 1975, pages 3634—35 by Balasubramanian et al. The use of asymmetry, however, requires a balanced multi-transistor storage cell of large size, as does the Denes system. Dennison et al have suggested, IBM Technical Disclosure Bulletin, June 1978, pages 190—93 and *id.,* October 1978, pages 1902—03, the replacement of these large static cells with single-transistor dynamic storage cells having capacitive storage elements whose leakage can be varied to attain a read-only mode of oparation. Such a memory chip requires bulky peripheral sources of light or other energy for operation, and its fabrication would be difficult and expensive.

Reference is also made to US—A—3755793 which discloses a latent image memory which is selectively operable as either a read/write memory or a read-only memory. The fixed data is represented by FET/Capacitor cells on the one hand, and CCD-cells on the other hand. To read the fixed data, first a bias voltage for the memory is raised to ground level, and a "0" is written into every cell. With the bias voltage still at ground level, a cell is read by applying a negative pulse to the word line associated with that cell, to produce a voltage spike fed to a respective sense amplifier; by this technique the result is always that the FET/capacitor cells will read "0", and the CCD cells will read "1". The cells of the memory are arranged in rows and columns, and the memory can be envisaged as though each row of cells is connected to a respective bit line, and each column has a respective word line connected to gates of the cells in that column. The word lines are selectively energised by respective word line drivers.

## Summary of the invention

The present invention achieves a read/write memory having apparatus additionally capable of storing a pattern of fixed, read-only data, and propounds a method of accessing such read-only data. In accordance with an aspect of the invention, such a memory contains an array of storage cells having field-effect transistors (FETs) with two different threshold voltages for establishing the read-only data. Control means accesses this data by first loading into storage elements of the cells different voltages, depending upon the thresholds of the associated FETs, and by thereafter selecting or addressing any of the cells in a normal read/write manner so as to transfer the stored voltage of that cell to an output. This allows the present dual-purpose memory to achieve a storage density substantially equal to that of a strictly read/write, single-transistor-per-cell memory, without either the large cells sizes or the expensive peripheral energy sources required by the prior art. The minimal increase in complexity of the present invention does not adversely affect either the array density or the data access time. Although additional time is necessary to load the read-only data before it can be used, this operation can be performed when a data processor would not be using the memory; when the read-only data is later accessed, no speed penalty whatsoever is paid for the additional read-only capability. Other features and advantages of the invention will appear to those skilled in the art from the following description of a preferred embodiment.

## Brief description of the drawings

Fig. 1 is a diagram of a memory system according to the invention.

Fig. 2 shows the structure of one type of storage-cell FET used in Fig. 1.

Fig. 3 details a word decoder used in Fig. 1.

Fig. 4 is a timing diagram illustrating the operation of the memory shown in Fig. 1.

## Detailed description

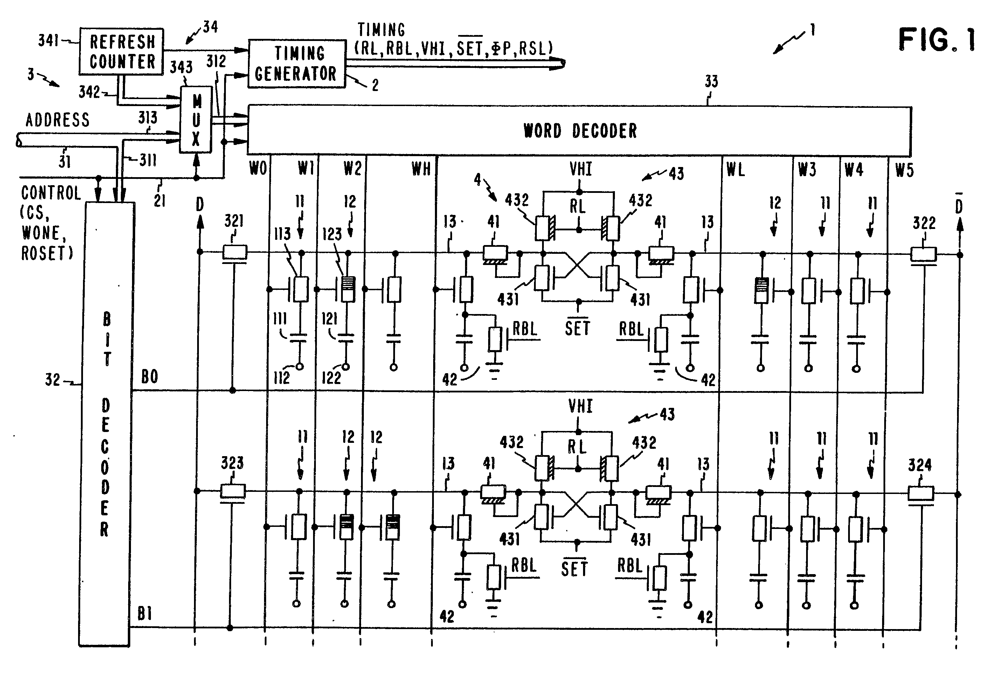

Fig. 1 shows a complete memory system according to the invention. An array 1 contains storage cells in a conventional matrix layout, such as the well-known "half-contact per cell" configuration. Cells 11 of a first type include a capacitor storage element 111 coupled to a fixed supply potential VDD at 112 and to the source of a field-effect transistor (FET) 113. FET 113 has a conventional enhancement-mode structure. Cells 12 of a second type have corresponding capacitor storage elements 121 and VDD connections 122. Their FETS 123, however, have a different structure, indicated by the horizontal bars at the drain contacts. Cells of these two types are located to form a desired pattern of read-only data, cells 11 representing a binary Zero, cells 12 representing a One. Cells of both types are interconnected by bit lines 13 coupled to the drains of FETs 113 and 123.

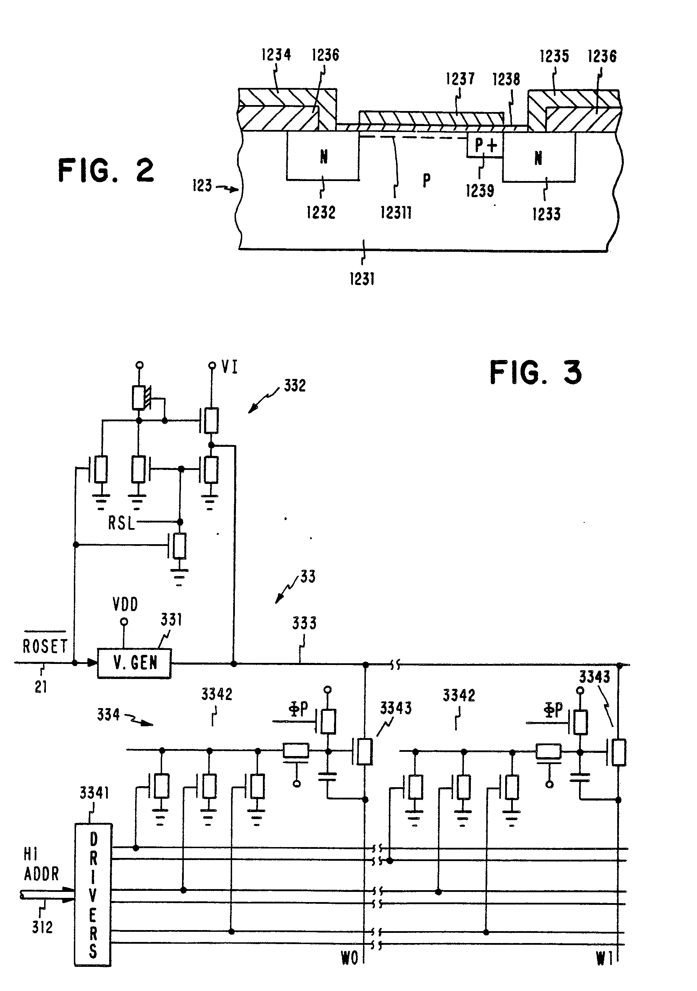

Fig. 2 details the structure of an FET 123. A P-doped substrate 1231 has N-doped source and drain diffusions 1232, 1233 with ohmic contacts to conductors 1234, 1235 deposited on top of insulating layer 1236. Conductive gate contact 1237 overlies thin insulating layer 1238. A localized highly P-doped region 1239 is located adjacent drain 1233; that is, region 1239 is located in a relatively small volume, rather than being distributed throughout channel region 12311 as would be done in conventional practice. Localized region 1239 raises the threshold voltage of FET 123 to a value VT2 higher than the threshold VT1 of an FET 113 which is otherwise similar but does not include an implant 1239, whenever contact 1235 is near ground potential. However, when contact 1235 is raised to a higher positive potential, region 1239 becomes depleted of holes; electron conduction through the entire channel 12311 then occurs when gate 1237 exceeds a threshold voltage which is about equal to VT1 of FET 113. For example, when drain 1235 is near ground potential, a positive voltage of about VT1=1.0 volt on gate 1237 is sufficient to invert the lightly-doped P material under gate 1237 to form N channel 12311, while about VT2=3.0 is required to establish conduction through implant 1239. The inclusion of regions 1239 in particular cells of array 1 may be done with a conventional masking step and ion implantation of boron or other suitable impurity material during fabrication of the memory.

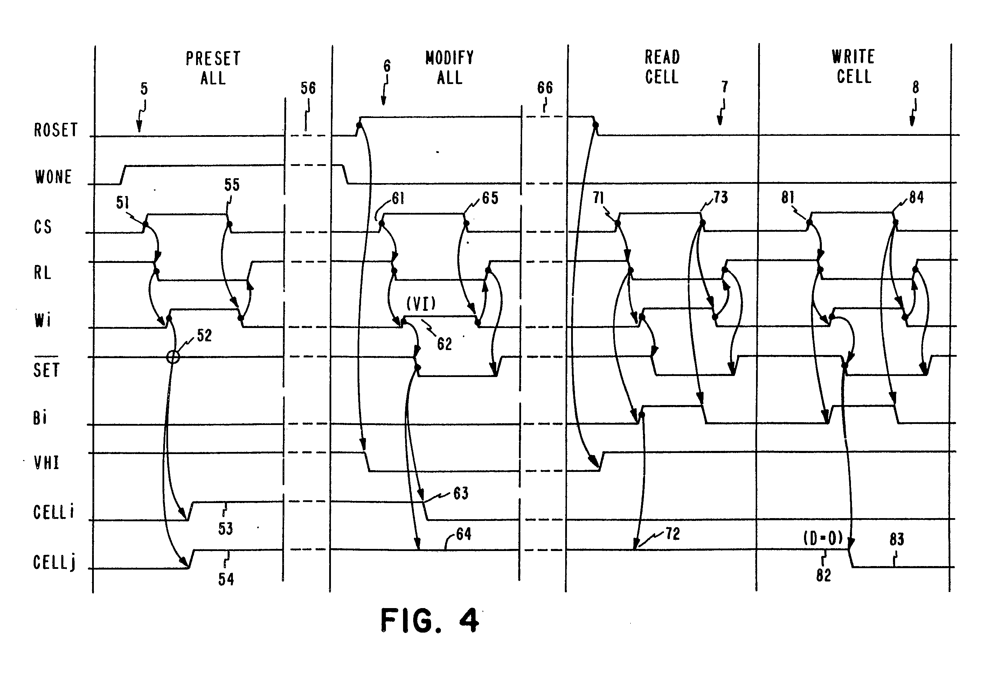

Returning to Fig. 1, the remaining circuitry may be considered as control means for transferring data to and from particular cells 11 and 12 of storage array 1. A timing generator 2 of conventional design responds to external control signals on lines 21 to produce various signals for sequencing the operations required for individual memory cycles, as discussed more fully in connnection with Fig. 4.

Address circuits 3 receive external address signals on lines 31. Bit decoder 32 may be a conventional decoder for converting binary coded signals on low-order address lines 311 into 1-of-N coded bit-select signals on lines B0, B1, etc. Each B line gates data signals form the FETs 113 or 123 in one row of array 1 via a bit line 13 thru an FET 321 to complementary data lines D, $\overline{D}$, and also in the reverse direction. That is, D, $\overline{D}$ serve as data input/output (I/O) lines for reading data from array 1 and for writing data into array 1 from an external source. Word decoder 33 converts coded binary signals on address lines 312 into 1-of-N word-select signals on lines W0, W1, etc. Each word-select line W connects to the gate contact of the FETs 113 or 123 in one column of array 1.

Relevant details of word decoder 33 will be described in conjunction with Fig. 3. The capacitor storage elements 111, 121 require periodic refreshing to retain their data signals. Conventional refresh circuits 34 may include a counter 341 for producing refresh addresses 342 and a multiplexer 343 for switching between addresses 342 and the high-order external address lines 313. Refresh circuits 34 may be physically located either on the same integrated-circuit chip with the remaining components of Fig. 1, or external to that chip.

Fig. 3 shows relevant details of word decoder 33, Fig. 1. A conventional voltage generator 331 supplied by VDD provides a bootstrapped first line voltage VDD+VT for allowing capacitors 111, 121 to be charged to the full VDD potential (i.e., a full binary One) when bit lines 13 are at VDD. VT may be about equal to VT1; it meed not be as high as VT2. Generator 331 is disabled whenever $\overline{ROSET}$ control signal 21 is low. Voltage generator 332 controls an intermediate voltage level VI. VI is a second line voltage, having a value less than the threshold voltage VT2 of the implanted array FETs 123, but higher than the threshold voltage VT1 of the normal array FETs 113. That is, if their drains are at ground potential, a gate voltage of VI volts is sufficient to turn on FETs 113, but FETs 123 will not conduct. VI may be produced by an on-chip supply from VDD, or it may be supplied externally. Both generators 331 and 332 are conventionally pulsed by a timing signal RSL related to RL. As shown by the diagram, generator 332 is enabled when $\overline{ROSET}$ is low. Therefore, line 333 is pulsed to a normal voltage VDD+VT when $\overline{ROSET}$ is high, but is pulsed only to an intermediate voltage VI when $\overline{ROSET}$ is low. Conventional decoder cirucits 334 distribute the line voltage 333 to the appropriate word-select lines W0, W1, etc. Drivers 3341 convert the coded high-order addresses 312 into complementary pairs, different combinations of which are detected by individual gating circuits 3342. Thus, only one at a time of the word lines W0, W1, etc., is coupled to line 333 by word switches 3343. These switches are gated by a conventional precharge signal φP from timing generator 2, Fig. 1, and include bootstrap capacitors to eliminate threshold drops across their FETs.

Returning again to Fig. 1, sense circuits 4 have a generally conventional design, but may be provided with additional functions in aid of the present invention, as will be pointed out. Bit lines 13 couple storage cells 11, 12 through transfer devices 41, which comprises depletion-mode FETs. Dummy storage cells 42 are conventionally controlled by word-select lines WH and WL and timing signal RBL to provide a reference voltage level for sense amplifiers 43. Each sense amplifier 43 includes cross-coupled FETs 431 and depletion-mode load FETs 432 forming a latch circuit. The sense-amplifier terminals marked $\overline{SET}$, RL and VHI are coupled to the indicated signals from timing generator 2 for presetting and loading storage array 1, and also for read/write memory functions, in a manner to be described in conjunction with Fig. 4.

Fig. 4 shows how the described system is used as both a read/write and a read-only memory. Broadly, the pattern of fixed or read-only data established by the two types of cells 11, 12 (Fig. 1) is loaded into the storage elements 111, 121 of the cells, after which the memory functions in a normal read-write mode, wherein the read-only data may be both read out and overwritten with arbitrary external data. More specifically, loading the read-only data involves a number of Preset cycles for storing a logic One voltage into all cells of the array, followed by a number of Modify cycles in which the storage capacitors of type-11 cells are discharged to a Zero voltage, while the type-12 cell capacitors are unaffected.

In Fig. 4, ROSET and WONE are control signals which may be received on lines 21, Fig. 1. (ROSET is the logic complement of $\overline{ROSET}$, Fig. 3). CS is a conventional chip-select control signal which initiates every memory cycle, and which is commonly used to synchronize timing generator 2. RL, $\overline{SET}$ and VHI are produced by generator 2 in a conventional manner. Wi and Bi are two of the word-select and bit-select signals produced by decoders 33 and 32 respectively. CELLi and CELLj represent the voltages on the storage capacitors 111 and 121 of a type-11 cell and a type-12 cell respectively; both CELLi and CELLj are coupled to word-select line Wi.

The sequence of Preset cycles 5 begins at any cell address, which may be supplied either from address lines 31 or from refresh circuits 341. Preset cycles 5 occur when WONE goes high (WONE=1) with a low level on ROSET (ROSET=0). When CS=1 at 51, RL=0 initiates select voltage Wi=1 for that particular address. Bi, however, is constrained by WONE=1 to remain low, so that all of the bit lines 13 are decoupled from the data I/O lines D, $\overline{D}$. Also, WONE=1 causes $\overline{SET}$ to remain high at 52. Since this condition prevents either of the FETs in latch 431 (Fig. 1) from conducting, the VHI=1 potential via FETs 432 appears on all bit lines 13. This high voltage allows a full binary One to be written into both the type-11 and the type-12 cells, as indicated by CELLi=1 and CELLj=1 at points 53, 54 Fig. 4. A falling edge of CS at 55 causes the Preset cycle to complete itself. Broken lines at 56 represent additional Preset cycles at different word addresses. Since all cells in the column addressed by Wi are preset to a binary One in a single cycle, the Preset sequence need only have a number of cycles equal to the number of columns in the storage array 1, just as in a conventional refresh operation; it is this fact which allows refresh counter 341 to act as an address source for Preset cycles 5.

The sequence of Modify cycles 6 is signalled by ROSET=1 after WONE=0. Again, CS=1 at 61 causes RL=0 to enable word-select line Wi at the beginning address of the sequence. This time, however, Wi only goes up to the intermediate voltage VI at point 62, instead of to VDD+VT as explained in connection with Fig. 3. At this time VHI=0, so that all bit lines 13 are coupled to ground potential through FETs 432 of all sense amplifiers 43. ROSET=1 also disables bit decoder 32, so that all Bi remain low, and all FETs 321 remain off. Then, since VI exceeds the threshold voltage of FETs 113 in all type-11 cells, those cells discharge toward Zero, as at 63. But, since VI is less than the higher threshold voltage of FETs 123 in all type-12 cells, those FETs do not conduct and the voltage on their storage capacitors 121 remains at VDD, as illustrated at point 64, Fig. 4. The trailing edge of CS closes this Modify cycle, leaving CELLi=0 and CELLj=1. Additional Modify cycles, indicated at 66, load the read-only data pattern of the remaining columns of array 1 into the appropriate capacitor storage elements. Here again, refresh counter 341 is a convenient source of address signals for sequencing the Modify cycles 6.

After cycles 5, 6 have loaded the pattern or image of fixed data into storage array 1, data from any selected cell may be read out to an external circuit (not shown) by a Read cycle 7, for which ROSET=0 and WONE=0. The leading edge CS=1 at time 71 followed by RL=0 raises the word-select and bit-select lines Wi, Bi for selecting the particular cell (either 11 or 12) specified by an externally supplied address in lines 31. Since RL=0 and $\overline{SET}$=0 and VHI=1, sense circuits 4, Fig. 1 function normally to sense and latch the contents of the addressed cell, say CELLj, at point 72, on bit lines 13; then the particular FET 321 selected by Bi transfers the (complementary) voltages on one pair of bit lines 13 to the data I/O lines D, $\overline{D}$ and thence to conventional interface circuits, not shown. Read cycle 7 closes when CS falls at 73.

A Write cycle 8 can write arbitrary variable external data in any storage cell 11 or 12 in a similar manner. CS=1 at 81 initiates the same sequence of events as at 71—72 in a read cycle. However, an externally supplied data input, shown as D=0 (and hence $\overline{D}$=1) at 82 forces the appropriate bit line 13 and sense amplifier 43 to the voltage of the input data at 83. Write cycle 8 closes with CS=0 at time 84, following the same sequence as for a Read cycle.

Thereafter, Read and Write cycles can occur in any order. Since Wi=VDD+VT for these cycles is sufficient to turn on both the type-11 and the type-12 storage cells, their structural differences, and hence the fixed, latent data pattern, make no difference. This data pattern can be reloaded into storage array 1 at any time, however, merely by re-executing the Preset and Modify cycles 5, 6. Refresh circuits 34 intersperse the required refresh cycles in a conventional manner by performing Read cycles 7 at the appropriate addresses in array 1.

Many modifications may be made within the spirit of the invention. For example, the Preset operation could be performed on all storage cells simultaneously, instead of column by column.

That approach was not taken here because it would impose higher peak power requirements. The same is true of the Modify operation. The time penalties paid by the sequential performance of these operations is ordinarily of little consequence, since the read-only data will usually be loaded during a power-up or cold-start operation of a data processor or controller. The preset cycles could also be achieved with a sequence of normal Write cycles, using binary Ones as the input data. In the structure of cells 12, the impurity region 1239 could be spread over the length of channel 1231 instead of being localized near drain 1233. This would require, however, that VT be increased from VT1 to VT2 for the word-select lines W.

**Claims**

1. A method of accessing fixed data contained in a read/write memory having an array of addressable storage cells (11, 12) each having an FET (113, 123) provided with one of two different threshold voltages and a storage element (111, 121), the storage cells being arranged in rows and columns, each row of storage cells being connected to a respective bit line (13) for conducting storage cell current for that row, each bit line (13) being selectively connectable to a data output line (D), each column of storage cells having a respective word line (Wi) connected to the gates of the storage cell FET's in that column, comprising the sequential steps of:
a) presetting all storage elements (111, 121) to a "One"-voltage by holding the bit lines (13) at the "One"-voltage while applying a select voltage (VDD+VT) higher than both of the FET threshold voltages to the word lines (Wi),
b) modifying the content of those storage cells (113) having the lower one of the two threshold voltages to a "Zero"-voltage by applying a "Zero"-voltage to the bit lines (13) while applying a select voltage (VI) intermediate between the two FET threshold voltages to the word lines (Wi), and
c) reading out the fixed data by selecting one of said storage cells by selectively connecting the appropriate bit line (13) to the data output line (D), and by applying a select voltage (VDD+VT) higher than both of the FET threshold voltages to the appropriate word line (Wi), so as to transfer the voltage of its storage element to said bit line and thence to said data output line.

2. A method as claimed in claim 1 in which each bit line (13) is held at the "One"-voltage in step (a) and at the "Zero"-voltage in step (b) by adjusting the voltage applied to a power supply connection (VHI) of a respective sense amplifier (43) connected to that bit line.

3. A read/write memory with capability to access fixed data, the memory having an array of addressable storage cells (11, 12) each having an FET (113, 123) provided with one of two different threshold voltages and a storage element (111, 121) the storage cells being arranged in rows and columns, each row of storage cells being connected to a respective bit line (13) for conducting storage cell current for that row, each bit line (13) being selectively connectable to a data output line (D), and being selectively connectable to a controlled voltage terminal (VHI) to which a "One"-voltage, or a "Zero"-voltage, can be applied, each column of storage cells having a respective word line (Wi) connected to the gates of the storage cell FET's in that column, a word decoder (13) operable in response to address signals and control signals to apply selected voltages to the word lines (Wi), whereby the fixed data is accessed by the sequence of:
a) presetting all storage elements (111, 121), to a "One"-voltage by selectively connecting the bit lines (13) to the "One'-voltage while the word decoder applies a select voltage (VDD+VT) higher than both of the FET threshold voltages to the word lines (Wi)
b) modifying the content of those storage cells (113) having the lower one of the two threshold voltages to a "Zero"-voltage by selectively connecting the bit lines (13) to the "Zero"-voltage while the word decoder applies a select voltage (VI) intermediate between the two FET threshold voltages to the word lines (Wi) and
c) reading out the fixed data by selecting one of said storage cells by selectively connecting the appropriate bit line (13) to the data output line (D), while the word decoder applies a select voltage (VDD+VT) higher than both of the FET threshold voltages to the appropriate word line (Wi), so as to transfer the voltage of its storage element to said bit line and thence to said data output line.

4. A memory according to claim 3 wherein the FETs having the higher of the two different threshold voltages each have a channel containing a localized highly doped region (1239).

**Patentansprüche**

1. Verfahren zum Zugreifen auf feste Daten in einem Schreib/Lese-Speicher, mit einem Feld adressierbarer Speicherzellen (11, 12) mit jeweils einem FET (113, 123) versorgt mit einer von zwei unterschiedlichen Schwellenspannungen, und einem Speicherelement (111, 121) wobei die Speicherzellen in Zeilen und Spalten angeordnet sind, wobei jede Speicherzellenzeile zum Leiten des Speicherzellenstroms für die Zeile mit einer entsprechenden Bitleitung (13) verbunden ist, wobei jede Bitleitung (13) selektiv mit einer Datenausgabeleitung (D) verbunden ist, und wobei jede Speicherzellenspalte jeweils eine Wortleitung (Wi) aufweist, welche mit den Gate-Anschlüssen der FETs der Speicherzellen in der Spalte verbunden ist, gekennzeichnet durch folgende aufeinanderfolgende Schritte:
a) Voreinstellen aller Speicherelemente (111. 121) auf eine "Eins"-Spannung durch Halten der Bitleitung (13) auf der "Eins"-Spannung, während eine Selektier-Spannung (VDD+VT) an die Wortleitungen (Wi) angelegt wird, welche höher ist als die beiden FET-Schwellenspannungen;
b) Modifizieren des Inhalts der Speicherzellen (113), während die geringere der beiden Schwellenspannungen auf einer "Null"-Spannung liegt, durch Anlegen einer "Null"-Spannung auf die Bitleitungen (13), während eine Selektier-Spannung (VI) zwischen den beiden FET-Schwellenspannungen an die Wortleitungen (Wi) angelegt wird; und durch

c) Auslesen der festen Daten durch Selektieren einer der Speicherzellen, indem die geeignete Bitleitung (13) selektiv an die Datenausgabeleitung (D) angeschlossen wird, und indem eine Selektier-Spannung (VDD+VT), welche höher ist als die beiden FET-Schwellenspannungen, an die geeignete Wortleitung Wi angeschlossen wird, so daß die Spannung des Speicherelements dieser Wortleitung zunächst zur Bitleitung und dann zur Datenausgabeleitung übertragen wird.

2. Verfahren nach Anspruch 1, dadurch gekennzeichnet, daß in Schritt

a) jede Bitleitung (13) auf der "Eins"-Spannung und in Schritt b) auf der "Null"-Spannung gehalten wird, indem die angelegte Spannung an einen Stromversorgungsanschluß (VHI) eines jeweiligen Sensor-Verstärkers (43) angeglichen wird, der mit der Bitleitung verbunden ist.

3. Schreib/Lese-Speicher zum Zugreifen auf feste Daten, mit einem Feld adressierbarer Speicherzellen (11, 12) mit jeweils einem FET (113, 123) versorgt mit einer von zwei interschiedlichen Schwellenspannungen, und einem Speicherelement (111, 121) wobei die Speicherzellen in Zeilen und Spalten angeordnet sind, wobei jede Speicherzellenzeile zum Leiten des Speicherzellenstroms für die Zeile jeweils mit einer Bitleitung (13) verbunden ist, wobei jede Bitleitung (13) selektiv mit einer Datenausgabeleitung (D) verbunden ist und selektiv an eine geregelte Spannungsquelle (VHI) angeschlossen werden kann, an der entweder eine "Eins"-oder eine "Null"-Spannung angelegt werden kann, wobei jede Speicherzellenspalte jeweils eine Wortleitung (Wi) aufweist, die mit den Gate-Anschlüssen der Speicherzellen-FETS in der Spalte verbunden ist, und wobei ein Wort-Decoder (33) auf Adressensignale und Steuersignale reagiert und Selektier-Spannungen an die Wortleitungen (Wi) anlegt, gekennzeichnet durch folgende Schrittfolge:

a) Voreinstellen aller Speicherelemente (111, 121) auf eine "Eins"-Spannung durch selektiven Anschluß der Bitleitungen (13) an die "Eins"-Spannung, während der Wort-Decoder eine Selektier-Spannung, welche höher ist als beide FET-Schwellenspannungen, an die Wortleitungen, (Wi) anlegt;

b) Modifizieren des Inhalts der Speicherzellen (113), während die geringere der beiden Schwellenspannungen auf einer "Null"-Spannung liegt, durch selektiven Anschluß der Bitleitungen (13) an die "Null"-Spannung, während der Wort-Decoder eine Selektier-Spannung zwischen den beiden Schwellenspannungen an die Wortleitungen (Wi) anlegt, und durch

c) Auslesen der festen Daten durch Selektieren einer der Speicherzellen, indem die geeignete Bitleitung (13) selektiv an die Datenausgabeleitung (D) angeschlossen wird, während der Wort-Decoder eine Selektier-Spannung (VDD+VT) an die geeignete Wortleitung (Wi) anlegt, welche höher ist als die beiden FET-Schwellenspannungen, so daß die Spannung des Speicherelements dieser Wortleitung zunächst zur Bitleitung und dann zur Datenausgabeleitung übertragen wird.

4. Speicher nach Anspruch 3, dadurch gekennzeichnet, daß die FETs mit der höheren der beiden unterschiedlichen Spannungen jeweils einen Kanal mit einem eingegrenzten, hochdotierten Bereich (1239) aufweisen.

## Revendications

1. Procédé d'accès à des données fixes contenues dans une mémoire à écriture-lecture ayant un réseau de cellules (11, 12) de stockage adressables chacune ayant un transistor à effet de champ TEC (113, 123) à une ou deux tensions différentes de seuil et un élément de stockage (111, 121), les cellules de stockage étant disposées en rangées et en colonnes, chaque rangée de cellules de stockage étant connectée à une ligne de bits (13) correspondante pour conduire le courant des cellules de stockage de cette rangée, chaque ligne de bits (13) pouvant être connectée de façon sélective à une ligne (D) de sortie de données, chaque colonne de cellules de stockage ayant une ligne (Wi) de mots correspondante connectée aux grilles des TEC des cellules de stockage dans cette colonne, ce procédé comprenant la séquence des phases suivantes:

a) prépositionner tous les éléments (111, 121) de stockage a une tension "UN" en maintenant les lignes (13) de bits à la tension "UN" tandis que l'on applique une tension (VDD+VT) de sélection plus élevée que l'une et l'autre des tensions de seuil des TEC aux lignes (Wi) de mot;

b) modifier le contenu de celles (11) des cellules de stockage qui ont la plus faible des deux tensions de seuil pour le ramener à une tension "ZERO" en appliquant une tension "ZERO" aux lignes (13) de bits tandis que l'on applique une tension (VI) de sélection intermédiaire entre les deux tensions de seuil des TEC aux lignes (Wi) de mots; et

c) lire les données fixes en sélectionnant l'une desdites cellules de stockage en connectant de façon sélective la ligne (13) de bits appropriée à la ligne (D) de sortie de données, et en appliquant une tension (VDD+VT) de sélection plus élevée que l'une et l'autre des deux tensions de seuil des TEC à la ligne (Wi) de mots appropriée, de façon à transférer la tension de son élément de stockage à ladite ligne de bits et de là à ladite ligne de sortie de données.

2. Procédé selon la revendication 1 dans lequel chaque ligne (13) de bits est maintenue à la tension "UN" pendant la phase (1) et à la tension "ZERO" pendant la phase (b) en ajustant la tension appliquée à une connexion (VHI) d'alimentation en énergie d'un amplificateur sélecteur (43) correspondant connecté à cette ligne de bits.

3. Mémoire à écriture-lecture avec possiblité d'accès à des données fixes, la mémoire ayant un réseau de cellules (11, 12) adressables ayant chacune un TEC à une on deux tensions différentes de seuil et un élément (111, 121) de stockage, les cellules de stockage étant disposées en rangées et en colonnes, chaque rangée de cellules de stockage étant connectée à une ligne (13) de bits correspondante pour conduire le courant des cellules de stockage de cette rangée, chaque ligne (13) de bits pouvant être connectée de façon sélective à une ligne (D) de sortie de données, et pouvant être connectée de façon sélective à une borne VHI de tension commandée à laquelle on peut appliquer une tension "UN" ou une tension "ZERO", chaque colonne de cellules de stockage ayant une ligne (Wi) de mots correspondante connectée aux grilles des TEC des cellules de stockage dans cette colonne, un décodeur (33) de mots pouvant fonctionner en réponse aux signaux d'adresse et aux signaux de commande pour appliquer des tensions sélectionnées aux lignes (Wi) de mots, l'accès aux données fixes étant obtenu par la séquence suivante:

a) prépositionner tous les éléments (111, 121) de stockage à une tension "UN" en connectant de façon sélective les lignes (13) de bits à la tension "UN" tandis que le décodeur de mots applique une tension sélectionnée (VDD+VT), plus élevée que l'une et l'autre des tensions de seuil des TEC, aux lignes (Wi) de mots;

b) modifier le contenu de celles (11) des cellules de stockage qui ont la tension de seuil la plus basse des deux pour le ramener à une tension "ZERO" en connectant de façon sélective les lignes (13) de bits à la tension "ZERO" tandis que le décodeur de mots applique une tension (VI) de sélection, intermédiaire entre les deux tensions de seuil des TEC, aux lignes (Wi) de mots et

c) lire les données fixes en sélectionnant l'une desdites cellules de stockage en connectant de façon sélective la ligne (13) de bits appropriée à la ligne (D) de sortie de données, tandis que le décodeur de mots applique une tension (VDD+VT) de sélection, plus élevée que l'une et l'autre des deux tensions de seuil des TEC, à ligne (Wi) de mots appropriée, de façon à transférer la tension de son élement de stockage à ladite ligne de bits et de là ladite ligne de sortie de données.

4. Mémoire selon la revendication 3, dans laquelle les TEC ayant la tension la plus élevée des deux tensions de seuil différentes possèdent chacun un canal contenant une région (1239) localisée fortement dopée.

FIG.1

0 044 977

FIG. 2

FIG. 3

FIG. 4